# EUROPEAN PATENT APPLICATION

(11) **EP 2 197 043 A1**
(43) Date of publication of application: **16.06.2010**
(21) Application number: 08832433.0
(22) Date of filing: 17.09.2008
(51) Int. Cl.: H01L 31/18, H01L 31/0224, C23C 14/08, C23C 14/35

(54) **SOLAR BATTERY MANUFACTURING METHOD**

(30) Priority: 19.09.2007 JP 2007242609
(71) Applicant: Ulvac, Inc., Chigasaki-shi Kanagawa 253-8543 (JP)
(72) Inventor: TAKAHASHI, Hirohisa, Sanmu-shi Chiba 289-1297 (JP); ISHIBASHI, Satoru, Sanmu-shi Chiba 289-1297 (JP); SUGIURA, Isao, Sanmu-shi Chiba 289-1297 (JP); TAKASAWA, Satoru, Sanmu-shi Chiba 289-1297 (JP)
(74) Representative: Eisenführ, Speiser & Partner
(86) International application number: PCT/JP2008/066768
(87) International publication number: WO 2009/038091

(57) **Abstract**

The present invention relates to a method for manufacturing a solar cell provided with a buffer layer or an intermediate electrode. The buffer layer is disposed between a rear electrode and a photovoltaic cell. The rear electrode is disposed on the opposite side of a light incidence side and functions as an electrode for extracting electric power. The intermediate electrode is disposed between a plurality of photovoltaic cells. The intermediate electrode or the buffer layer comprises a ZnO-based transparent conductive film. The method comprises: forming the intermediate electrode or the buffer layer by sputtering a target on which a formation material of the transparent conductive film is provided while applying sputtering voltage to generate a horizontal magnetic field on a surface of the target. The intermediate electrode or the buffer layer is formed through sputtering at a sputtering voltage of 340V or less.

## Description

### [Technical Field]

The present invention relates to a method for manufacturing a solar cell.
Priority is claimed on Japanese Patent Application No. 2007-242609, filed September 19, 2007, the contents of which are incorporated herein by reference.

### [Background Art]

ITO (In₂O₃-SnO₂), a transparent conductive material, has been used to form the electrodes of solar cells. A recent concern regarding ITO is a possible increase in price due to unavailability of indium (In), which is a rare metal used to synthesize ITO. As an alternative transparent conductive material to ITO, a ZnO-based material has been recognized for its availability and low price (see, for example, Patent Document 1). The ZnO-based material is suited for sputtering to deposit a uniform film on a large-sized substrate. A film may be deposited in a simple manner by substituting a target of the ZnO-based material for an In₂O₃-based material. The ZnO-based material does not include lower oxide (InO) having high insulating property which the In₂O₃-based material possesses.
[Patent Document 1] Japanese Unexamined Patent Application, First Publication No. H9-87833

### [Disclosure of Invention]

### [Problems to be Solved by the Invention]

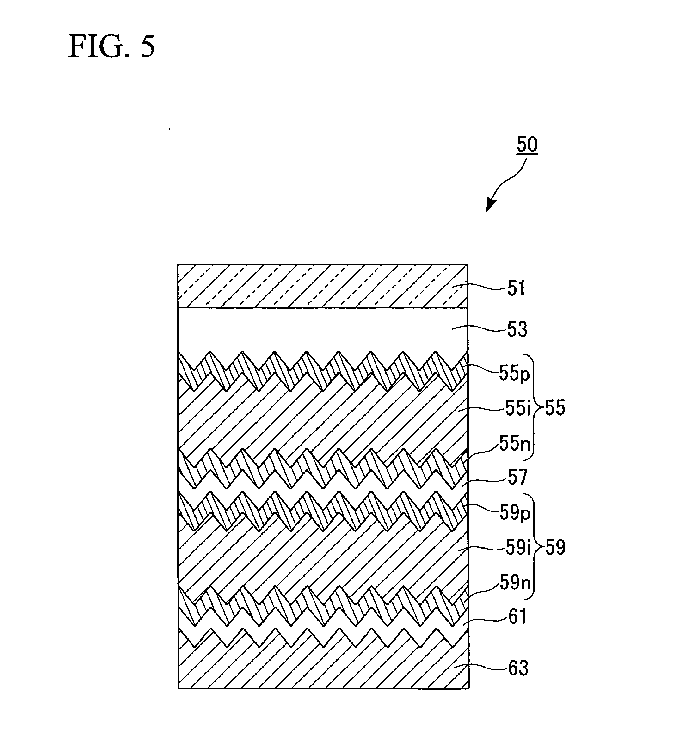

As illustrated in FIG. 5, an existing solar cell includes: a glass substrate 51 constituting a surface of the solar cell; an upper electrode 53 provided on the glass substrate 51; a top cell 55 formed of amorphous silicon; an intermediate electrode 57 being a transparent conductive film and disposed between the top cell 55 and the bottom cell 59, which will be described later; a bottom cell 59 formed of microcrystal silicon; a buffer layer 61 being a transparent conductive film; and a rear electrode 63 being a metal film, which constituents are laminated together.
It has been proposed to employ a ZnO-based film as the intermediate electrode 57 or the buffer layer 61 of the thus-configured solar cell. However, if the intermediate electrode 57 is formed through magnetron sputtering, there is a possibility that plasma-excited negative ions are accelerated and bombarded onto the substrate, and this bombardment may cause damage to the underlying top cell 55. Similarly, in the process of forming the buffer layer 61, the underlying bottom cell 59 may be damaged.

In the event that light incident on the glass substrate 51 passes through one photovoltaic cell (i.e., the top cell 55 or the bottom cell 59), the light may enter another photovoltaic cell to generate electricity so as to improve power generation efficiency of the solar cell. It is therefore necessary for the intermediate electrode 57 to be highly light transmissive so that light passing through the top cell 55 can enter the bottom cell 59 to generate electricity. It is also necessary for the buffer layer 61 to be highly light transmissive so that light passing through the bottom cell 59 is reflected at the rear electrode 63 and re-enter the bottom cell 59 to generate electricity.

The invention is made in view of the aforementioned circumstances and an object thereof is to provide a method for manufacturing a solar cell including a transparent conductive film of a highly light transmissive ZnO-based material, the method can reduce damage to underlying layers.

### [Means for Solving the Problems]

The invention employs the followings in order to solve the aforementioned problems and achieve the object.
(1) A method for manufacturing a solar cell provided with a buffer layer or an intermediate electrode, the buffer layer being disposed between a rear electrode and a photovoltaic cell, the rear electrode functioning as an electrode for taking out electric power at a light incidence side of the solar cell, the intermediate electrode being disposed between a plurality of photovoltaic cells and the intermediate electrode or the buffer layer being configured by a ZnO-based transparent conductive film, the method including a step of: forming the intermediate electrode or the buffer layer by sputtering a target on which a material for forming the transparent conductive film is provided while applying sputtering voltage to generate a horizontal magnetic field on a surface of the target, wherein the intermediate electrode or the buffer layer is formed through sputtering at a sputtering voltage of not higher than 340V.
(2) In the step of forming the intermediate electrode or the buffer layer, the target may preferably be sputtered with a maximum horizontal magnetic field strength on the surface thereof being not less than 600 gauss.

According to the method for manufacturing a solar cell as recited in (1), low sputtering voltage can be employed to form the intermediate electrode or the buffer layer and, therefore, acceleration of plasma-excited negative ions and bombardment of the negative ions onto the substrate can be suppressed. Accordingly, in the manufacturing process of the solar cell, damage to underlying films of a photovoltaic cell and the like disposed adjacent to the intermediate electrode or the buffer layer, can be reduced. With the sputtering voltage of 340V or less, a thin ZnO-based film with a well-defined crystalline lattice can be deposited, therefore a transparent conductive film with low specific resistance can be provided.

(3) In the step of forming the intermediate electrode or the buffer layer, the target may preferably be sputtered while introducing oxygen gas or oxygen atom-containing gas.
In this case, an oxygen-rich ZnO-based film is provided and, therefore, a highly light transmissive transparent conductive film can be obtained.

(4) A magnetic field generating device for generating a horizontal magnetic field on the target surface may preferably include a first magnet with a first polarity and a second magnet with a second polarity disposed along a rear surface of the target; and the second magnet is disposed to surround the first magnet.
In this case, a strong horizontal magnetic field can be generated on the target surface to facilitate formation of a ZnO-based film with a well-defined crystalline lattice. Thus, a transparent conductive film with a low specific resistance and a high heat resistance can be provided.

(5) In the step of forming the intermediate electrode or the buffer layer, the target may preferably be sputtered while relative positions of the magnetic field generating device for generating a horizontal magnetic field on the target surface and the target are changing.
In this case, a non-eroded area can be reduced. In addition, efficiency in the use of the target can be increased and introduced power can be increased.

(6) In the step of forming the intermediate electrode or the buffer layer, the target may preferably be sputtered while relative positions of a substrate on which the intermediate electrode or the buffer layer is to be formed and the target are changing.
In this case, a uniform transparent conductive film can be provided on the entire substrate.

(7) The sputtering voltage may preferably be applied from both a direct current power supply and a high-frequency power supply.
In this case, low sputtering voltage can be employed. With such the low sputtering voltage, acceleration of the plasma-excited negative ions and bombardment of the negative ions to the substrate can be suppressed. Accordingly, in the manufacturing process of the solar cell, damage to underlying films of a photovoltaic cell and the like disposed adjacent to the intermediate electrode or the buffer layer, can be reduced.

### [Effect of the Invention]

According to the invention, low sputtering voltage can be employed to form the intermediate electrode or the buffer layer and, therefore, acceleration of plasma-excited negative ions and bombardment of the negative ions to the substrate can be suppressed. Thus, since damage to underlying layers can be reduced, a solar cell that includes a transparent conductive film of a highly light transmissive ZnO-based material can be provided.

### [Brief Description of the Drawings]

[FIG. 1] FIG. 1 schematically illustrates a configuration of a magnetron sputtering apparatus according to an embodiment of the invention.
[FIG 2] FIG. 2 is a plan view of a film deposition chamber.
[FIG. 3] FIG. 3 is a front view of a sputtering cathode mechanism.
[FIG. 4] FIG. 4 illustrates a modified embodiment of the magnetron sputtering apparatus.
[FIG. 5] FIG. 5 schematically illustrates a configuration of a solar cell.
[FIG. 6] FIG. 6 is a graph illustrating a relationship between horizontal magnetic field strength and sputtering voltage.
[FIG. 7] FIG. 7 is a graph illustrating a relationship between thickness of a ZnO-based film and specific resistance.
[FIG. 8] FIG. 8 is a graph illustrating a relationship between sputtering voltage and specific resistance.

### [Reference Numerals]

- 5:: substrate
- 10:: magnetron sputtering apparatus
- 22:: target
- 26:: DC power supply (voltage applying device)
- 30:: magnetic circuit (magnetic field generating device)
- 31:: first magnet
- 32:: second magnet
- 50:: solar cell
- 51:: glass substrate (substrate)
- 57:: intermediate electrode
- 61:: buffer layer

### [Best Mode for Implementing the Invention]

Referring now to the drawings, a method for manufacturing a solar cell according to an embodiment of the invention will be described.

### (Magnetron Sputtering Apparatus)

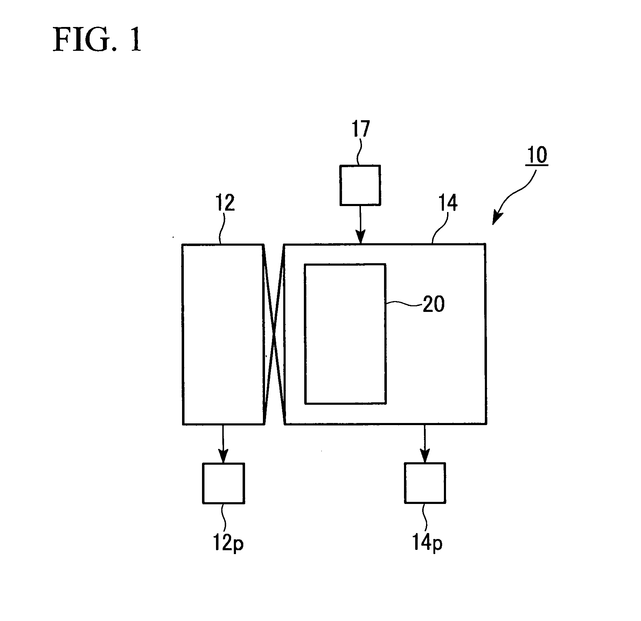

FIG. 1 schematically illustrates a configuration of a magnetron sputtering apparatus. A sputtering apparatus 10 according to the present embodiment is an interback-type sputtering apparatus, which includes a carry-in/out chamber 12 for a substrate (not shown in FIG.1) and a film deposition chamber 14 in which a film is deposited on the substrate. A roughing exhauster 12p, such as a rotary pump, is connected to the carry-in/out chamber 12. A high-vacuum exhauster 14p, such as a turbo-molecular pump, is connected to the film deposition chamber 14. In the sputtering apparatus 10 according to the present embodiment, the substrate supported in a vertical position is carried into the carry-in/out chamber 12, and then the carry-in/out chamber 12 is evacuated by the roughing exhauster 12p. Next, the substrate is conveyed into the film deposition chamber 14 which is highly evacuated by a high-vacuum exhauster 14p, and then a film is deposited on the substrate. The substrate having a film deposited thereon is taken out via the carry-in/out chamber 12.

A gas supply unit 17 which supplies sputtering gas, such as Ar, is connected to the film deposition chamber 14. The gas supply unit 17 may also supply reactant gas, such as O₂. A sputtering cathode mechanism 20 is disposed vertically in the film deposition chamber 14.

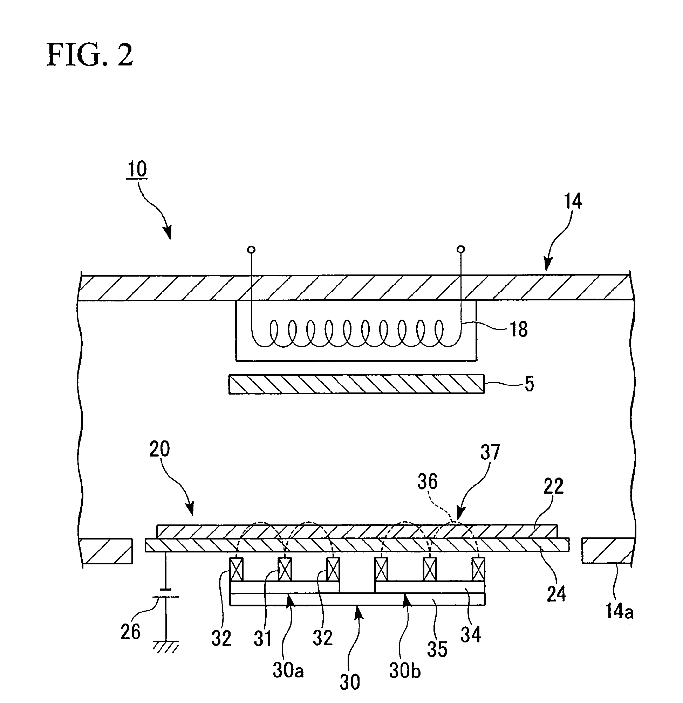

FIG. 2 is a plan view of the film deposition chamber 14. The sputtering cathode mechanism 20 is disposed at one width-direction end of the film deposition chamber 14. A heater 18 for heating the substrate 5 is disposed at another width-direction end of the film deposition chamber 14.

The sputtering cathode mechanism 20 mainly includes a target 22, a backing plate 24 and a magnetic circuit 30. The backing plate 24 is connected to a DC power supply 26 and held at negative potential. A target 22 brazed with a formation material of the ZnO-based film is disposed on a surface of the backing plate 24. The formation material of the ZnO-based film is ZnO to which an Al-containing material is doped. Sputtering gas is supplied into the film deposition chamber 14 from the gas supply unit 17, and sputtering voltage is applied to the backing plate 24 by the DC power supply 26. Then, sputtering gas ions excited by plasma within the film deposition chamber 14 bombard the target 22 so that atoms of the formation material of the ZnO-based film are ejected. The ejected atoms adhere to the substrate 5 to provide a film of the ZnO-based material on the substrate 5.

A magnetic circuit 30 generating a horizontal magnetic field on a surface of the target 22 is placed along a back surface of the backing plate 24. The magnetic circuit 30 includes a first magnet 31 and a second magnet 32 which are polarized opposite to each other at their surfaces facing the backing plate 24.

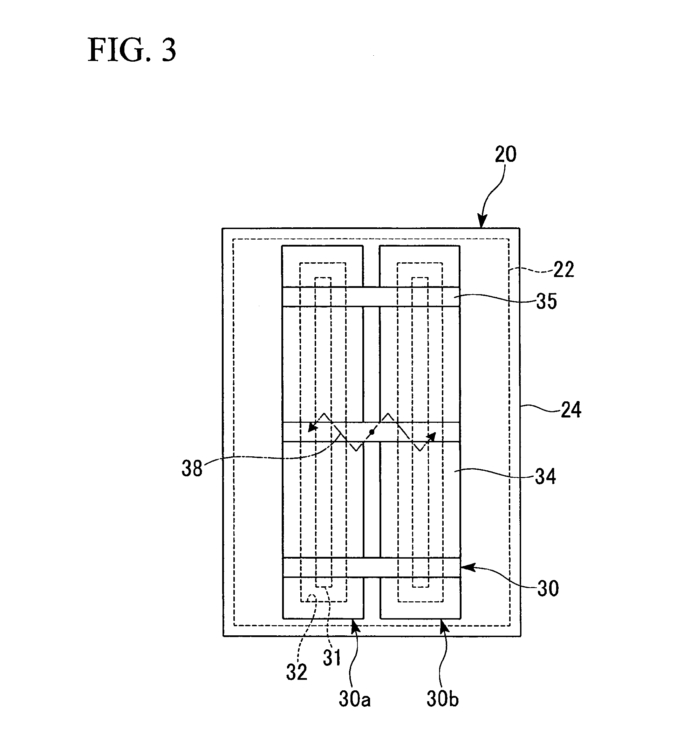

FIG. 3 is a rear elevation of the sputtering cathode mechanism 20. The first magnet 31 is disposed linearly. The second magnet 32 is disposed in a frame configuration surrounding the first magnet 31 with a predetermined distance from a periphery of the first magnet 31.
The first magnets 31 and the second magnets 32 are mounted on a yoke 34 to form a magnetic circuit unit 30a. Multiple (two in the present embodiment) magnetic circuit units 30a and 30b are connected to each other with a bracket 35 to form the magnetic circuit 30.

As illustrated in FIG. 2, a magnetic field represented by a magnetic field line 36 is generated by the first magnet 31 and the second magnet 32 which are polarized opposite to each other at the backing plate 24 side thereof. According to this configuration, positions 37 with a vertical magnetic field of 0 (and the maximum horizontal magnetic field) appear on the surface of the target 22 between the first magnet 31 and the second magnet 32. As high-density plasma is generated at the positions 37, the film deposition speed is accelerated.

The target 22 is eroded most deeply at the positions 37. The magnetic circuit 30 may fluctuate horizontally so that the positions 37 are not fixed in order to increase the efficiency in the use of the target (i.e., lifetime of the target) and that cooling efficiency of the target and the cathode is increased in order to improve arcing or other property. The eroded configuration is rectangular or semicircular at upper and lower ends of the target 22. Thus, the magnetic circuit 30 may also fluctuate vertically. In particular, a pair of horizontal and vertical actuators (not illustrated) are provided to make the bracket 35 of the magnetic circuit 30 reciprocate horizontally and vertically. When these horizontal and vertical actuators are driven at different cycles, the magnetic circuit 30 fluctuates in a zigzag manner within a surface parallel to the target 22.

### (Modified Embodiment)

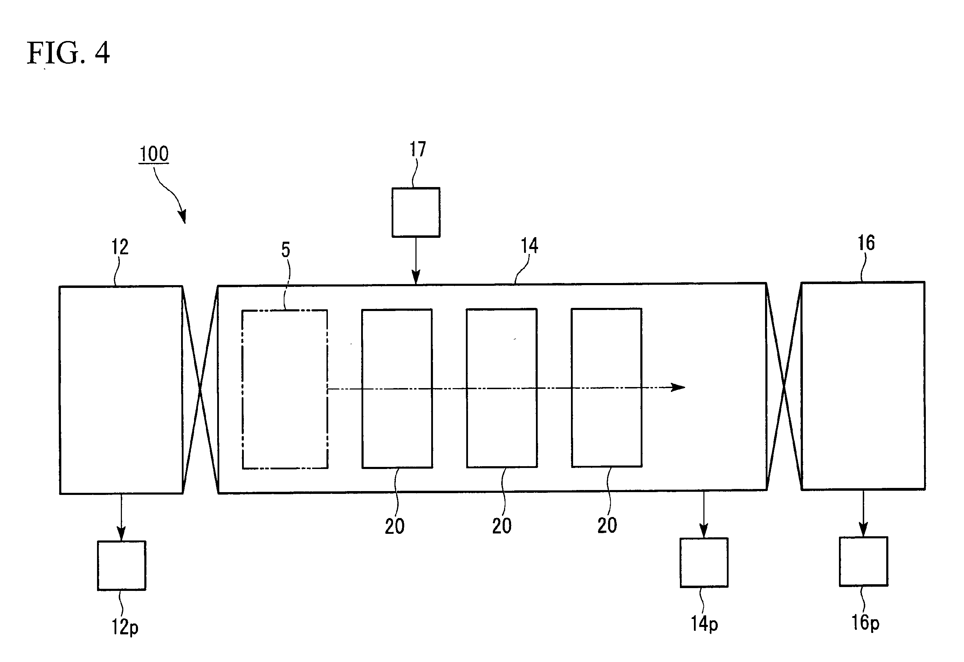

FIG. 4 illustrates a modified embodiment of the magnetron sputtering apparatus. A sputtering apparatus 100 according to the modified embodiment is an in-line type sputtering apparatus which includes a carry-in chamber 12, a film deposition chamber 14 and a carry-out chamber 16 in this order. In the sputtering apparatus 100, the substrate supported in a vertical position is carried into the carry-in chamber 12 and then the carry-in chamber 12 is evacuated by a roughing exhauster 12p. Next, the substrate 5 is conveyed into the film deposition chamber 14 which is highly evacuated by a high-vacuum exhauster 14p where a film is deposited on the substrate 5. The substrate 5 having a film deposited thereon is taken out via the carry-out chamber 16 which is evacuated by a roughing exhauster 16p.

Multiple (three in the modified embodiment) sputtering cathode mechanisms 20 are disposed in a conveyance direction of the substrate 5 within the film deposition chamber 14. Each sputtering cathode mechanism 20 is configured in the same manner as that of the embodiment described above. In the modified embodiment, a ZnO-based film is formed on a surface of the substrate 5 with the each sputtering cathode mechanisms 20 as the substrate 5 passes in front of the sputtering cathode mechanisms 20.
In this manner, a uniform ZnO-based film can be deposited with increased throughput of the film deposition process.

### (Solar cell)

Referring now to FIG. 5, a solar cell manufactured in the method according to the present embodiment will be described. FIG. 5 schematically illustrates a configuration of the solar cell.
As illustrated in FIG. 5, the solar cell 50 includes: a glass substrate 51 constituting a surface of the solar cell 50; an upper electrode 53 comprising a transparent conductive film and provided on the glass substrate 51; a top cell 55 formed of amorphous silicon; an intermediate electrode 57 being a transparent conductive film and disposed between the top cell 55 and the bottom cell 59, which will be described later; a bottom cell 59 formed of microcrystal silicon; a buffer layer 61 being a transparent conductive film; and a rear electrode 63 being a metal film; which are laminated together. Thus, the solar cell 50 is an a-Si/micro crystallite Si tandem solar cell. In such a tandem solar cell 50, short wavelength light is absorbed by the top cell 55 and long wavelength light is absorbed by the bottom cell 59. With this configuration, power generation efficiency can be increased.

The top cell 55 has a three layer structure consisting of a p-layer (55p), an i-layer (55i) and an n-layer (55n). The i-layer (55i) is formed of amorphous silicon. The bottom cell 59 also has a three-layer structure consisting of a p-layer (59p), an i-layer (59i) and an n-layer (59n) like the top cell 55. The i-layer (59i) is formed of microcrystal silicon.

In the thus-structured solar cell 50, when energy particles called photons included in sunlight bombard the i-layer, electrons and electron holes (i.e., holes) are generated by a photovoltaic effect. The electrons move toward the n-layer and the electron holes move toward the p-layer. The electrons generated by the photovoltaic effect are extracted from the upper electrode 53 and the rear electrode 63. In this manner, light energy is converted to electrical energy.

Sunlight incident from the glass substrate 51 side passes through the layers and is reflected by the rear electrode 63. In order to increase conversion efficiency of the light energy, the solar cell 50 employs a texture structure which provides a prism effect for extending an optical path of sunlight incident into the upper electrode 53 and a light trapping effect.

The intermediate electrode 57 and the buffer layer 61 of the solar cell 50 according to the present embodiment are configured by a ZnO-based film (i.e., a transparent conductive film) formed with the magnetron sputtering apparatus 10 described above. If the intermediate electrode 57 is formed through magnetron sputtering, there is a possibility that plasma-excited negative ions are accelerated and bombarded onto the substrate, and this bombardment may cause damage to the underlying top cell 55. Similarly, in the process of forming the buffer layer 61, the underlying bottom cell 59 may be damaged. It is therefore necessary that the intermediate electrode 57 or the buffer layer 59 is formed while suppressing damage to the underlying layers. The buffer layer 61 is provided also in order to prevent diffusion of the metal layer used as the rear electrode 63.

### (Method for Manufacturing Solar cell)

### (First Embodiment)

In a first embodiment, a solar cell 50 is manufactured with a sputtering device 10 illustrated in FIGS. 1 to 3.
The upper electrode 53 is formed on the glass substrate 51 in the same manner as that of the intermediate electrode 57, which will be described later. The top cell 55 is then formed on the upper electrode 53. After the top cell 55 is formed, an Al-added ZnO (AZO) film is formed on the top cell 55 as the intermediate electrode 57.

A method for forming the intermediate electrode 57 through magnetron sputtering will be described below.
In the target 22 illustrated in FIG. 2, a ZnO material to which Al₂O₃ is doped in an amount of 0.5 to 10.0 wt% (2.0 wt% in the present embodiment) is employed to form the transparent conductive film. A non-alkali glass substrate 51 is carried into the film deposition chamber 14 and heated as needed with the heater 18. When the glass substrate 51 is heated with the heater 18, temperature of the heated glass substrate 51 may preferably be 200°C or less. This is because: since the upper electrode 53 is formed on the glass substrate, there is substantially no temperature restriction (i.e., the maximum temperature is about 600° C); on the other hand, during deposition of the intermediate electrode 57 and the buffer layer 61, it is necessary to consider the heat resistance of previously formed power generation layers (i.e., the top cell 55 or the bottom cell 59). The film deposition chamber 14 is highly evacuated by the high-vacuum exhauster 14p. Ar gas is introduced into the film deposition chamber 14 as a sputtering gas from the gas supply unit 17. Pressure in the film deposition chamber 14 is kept at 2 to 10 mTorr (5 mTorr in the present embodiment). Electric power having power density of 1 to 8 W/cm² (4 W/cm² in the present embodiment) is introduced to the backing plate 24 from the DC power supply 26 while the magnetic circuit 30 is fluctuating. Although the thus-deposited film is not annealed because the film is deposited with heat, the deposited film may be annealed alternatively.

As described above, the conductivity of the ZnO-based film increases when Al or other substances enter Zn sites in the crystals, form ions and emit free electrons. An Al₂O₃-doped ZnO target is sputtered to form an Al- doped ZnO (AZO) film to obtain a transparent conductive film with low specific resistance. In this manner, a transparent conductive film with especially low specific resistance among other ZnO-based films can be obtained.

The present inventors evaluated dependency of specific resistance of the ZnO-based film to magnetic field strength. For the evaluation, the ZnO-based film was formed at two levels: a first level in which the magnetic circuit 30 was controlled to have a 300-gauss horizontal magnetic field strength on the target surface; and a second level in which the magnetic circuit 30 was controlled to have 1500-gauss horizontal magnetic field strength on the target surface. Specific resistance of the obtained ZnO-based films of each level having a thickness of 2000, 5000, 10000 and 15000 angstroms was measured.

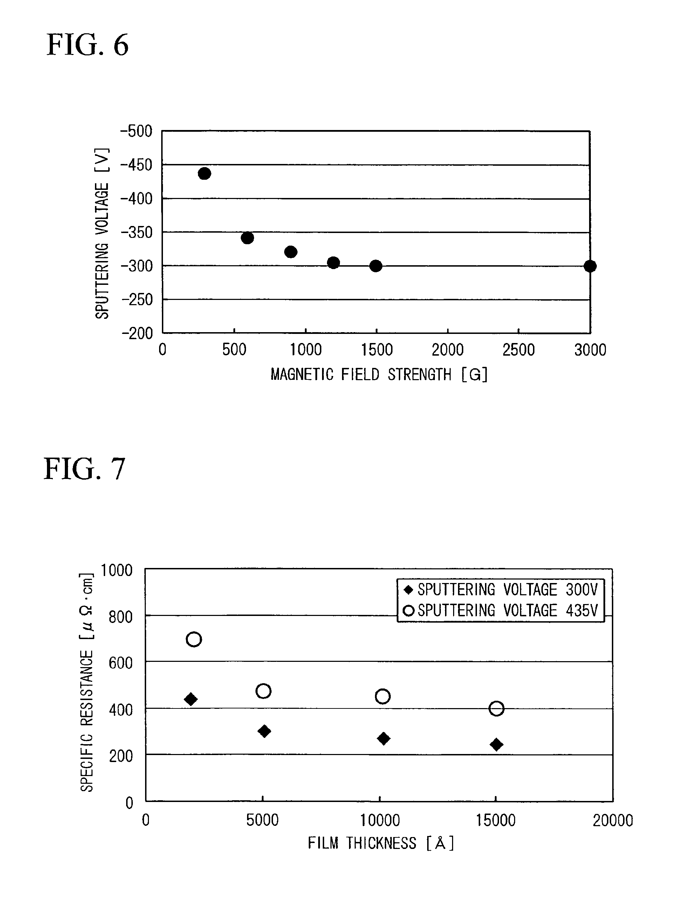

FIG. 6 is a graph illustrating a relationship between horizontal magnetic field strength and sputtering voltage. As horizontal magnetic field strength increases, the sputtering voltage decreases as illustrated in FIG. 6. Generally, sputtering voltage is affected by discharge impedance (i.e., target voltage/target current) and the discharge impedance is affected by magnetic field strength on the target surface. As magnetic field strength becomes large, plasma density also becomes large and, as a result, sputtering voltage decreases. Sputtering voltage of the first level (horizontal magnetic field strength: 300 gauss) is about 450V and sputtering voltage of the second level (horizontal magnetic field strength: 1500 gauss) is about 300V

FIG. 7 is a graph illustrating a relationship between the thickness of the ZnO-based film and specific resistance. Since specific resistance of the ZnO-based material depends on the film thickness, the specific resistance decreases as the thickness increases.
The specific resistance of the ZnO-based film formed at the second level (1500 gauss, 300V) is smaller than that of the first level (300 gauss, 435V). The reason for this phenomenon is considered as follows. Since the specific resistance depends on the film thickness, the crystalline lattice of the ZnO-based material is difficult to define. A ZnO-based film formed at a high sputtering voltage (i.e., a weak magnetic field) has a high specific resistance because its crystalline lattice is not well defined. In this case, when the film thickness of the ZnO-based film is increased, the crystalline lattice becomes well-defined, thereby the specific resistance of such a ZnO-based film tends to decrease. However, since the crystalline lattice is poorly defined, such a ZnO-based film has larger specific resistance compared with that of a thin ZnO-based film formed at a low sputtering voltage (i.e., a strong magnetic field).

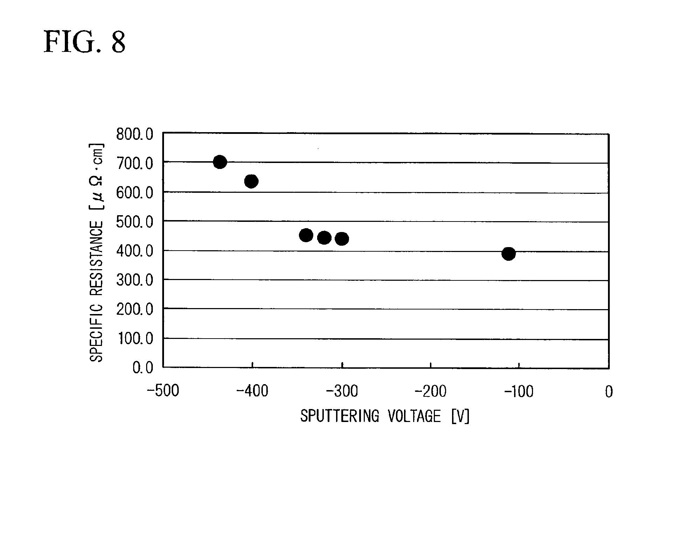

FIG. 8 is a graph illustrating a relationship between sputtering voltage (the sputtering voltages are described as negative potential) and specific resistance when a substrate is heated to 200°C and a 2000 angstrom-thick ZnO-based film is formed. The graph shows: the specific resistance is about 400 µΩcm in an absolute value range of the sputtering voltage of 340 or less; and the specific resistance increases rapidly in an absolute value range of the sputtering voltage of greater than 340V.

It is therefore desirable to form the ZnO-based film by sputtering with the sputtering voltage of 340V or less and with the maximum horizontal magnetic field strength on the target surface of not less than 600 gauss (see FIG. 6). Under these conditions, a ZnO-based film with a well-defined crystalline lattice can be provided and a ZnO-based film with low specific resistance (i.e., a thin film having specific resistance of 500 µΩcm or less) can be obtained.

With the decreased sputtering voltage, acceleration of plasma-excited negative ions and bombardment of the negative ions to the substrate can be suppressed. With the sputtering voltage of 340V or less, a ZnO-based film with low specific resistance can be formed and, therefore, acceleration of plasma-excited negative ions and bombardment of the negative ions to the substrate can be suppressed. Accordingly, damage to the underlying films, such as a photovoltaic cell disposed adjacent to the intermediate electrode or the buffer layer, can be reduced.

After the intermediate electrode 57 is formed as described above, the bottom cell 59 is formed thereon. After the bottom cell 59 is formed, an Al-doped ZnO (AZO) film is formed on the bottom cell 59 as the buffer layer 61 in the same manner as that of the intermediate electrode 57. When forming the intermediate electrode 57 or the buffer layer 61, a ZnO (GZO) film to which Ga, not Al, is doped may be formed.
Then, after the buffer layer 61 is formed, the rear electrode 63 comprising a metal film, such as an Ag film or an Al film, is formed thereon to complete the solar cell 50.

According to the present embodiment, a method for manufacturing a solar cell 50 provided with the buffer layer 61 being disposed between the bottom cell 59 and the rear electrode 63 that functions as an electrode for extracting electric power at a light incidence side of the solar cell 50, or the intermediate electrode 57 being disposed between the top cell 55 and the bottom cell 59 and the intermediate electrode 57 or the buffer layer 61 comprising a ZnO-based transparent conductive film, the method includes: forming the intermediate electrode 57 or the buffer layer 61 by sputtering a target on which a formation material of the transparent conductive film is provided while applying a sputtering voltage to generate a horizontal magnetic field on a surface of the target 22. The intermediate electrode 57 or the buffer layer 61 is formed through sputtering at the sputtering voltage of 340V or less.
In the process of forming the intermediate electrode 57 or the buffer layer 61, the target 22 is sputtered with the maximum horizontal magnetic field strength on the surface thereof being not less than 600 gauss.

According to this configuration, since the intermediate electrode 57 or the buffer layer 61 is formed with low sputtering voltage, acceleration of the plasma-excited negative ions and bombardment of the negative ions to the substrate can be suppressed. Accordingly, in the manufacturing process of the solar cell 50, damage to underlying films of a photovoltaic cell (i.e., the top cell 55 or the bottom cell 59) and the like disposed adjacent to the intermediate electrode 57 or the buffer layer 61, can be reduced. With the sputtering voltage of 340V or less, a thin ZnO-based film with a well-defined crystalline lattice can be deposited, thereby a transparent conductive film with low specific resistance can be obtained.

### (Second Embodiment)

In the solar cell 50, in the event that light incident on the glass substrate 51 passes through one photovoltaic cell (i.e., the top cell 55 or the bottom cell 59) and enters another photovoltaic cell to generate electricity, power generation efficiency of the solar cell 50 may be improved. It is therefore necessary for the intermediate electrode 57 to be highly light transmissive so that light passing through the top cell 55 can enter the bottom cell 59 to generate electricity. It is also necessary for the buffer layer 61 to be highly light transmissive so that light passing through the bottom cell 59 is reflected at the rear electrode 63 and re-enters the bottom cell 59 to generate electricity.
In a second embodiment, a highly light transmissive oxygen-rich ZnO film is formed as a transparent conductive film which constitutes the intermediate electrode 57 or the buffer layer 61.

In the target 22 illustrated in FIG. 2, ZnO is employed as a formation material of the transparent conductive film. A non-alkali glass substrate 51 is carried into the film deposition chamber 14 and heated as needed with the heater 18. When the glass substrate 51 is heated with the heater 18, temperature of the heated glass substrate 51 may preferably be 200°C or less (200°C in the present embodiment). The film deposition chamber 14 is highly evacuated by the high-vacuum exhauster 14p. Ar gas is introduced into the film deposition chamber 14 in an amount of 50 to 400 sccm as sputtering gas from the gas supply unit 17 and O₂ gas is introduced into the film deposition chamber 14 in an amount of 0 to 20 sccm as reactive gas from the gas supply unit 17. Pressure in the film deposition chamber 14 is kept at 2 to 10 mTorr. Electric power having power density of 1 to 8 W/cm² is introduced to the backing plate 24 from the DC power supply 26 while the magnetic circuit 30 is fluctuating.

In this manner, an oxygen-rich ZnO film can be formed through sputtering while introducing O₂ gas. The oxygen-rich ZnO film is highly light transmissive although the specific resistance thereof is large. Accordingly, a transparent conductive film with excellent optical property can be provided. Note that since thickness of the intermediate electrode 57 or the buffer layer 61 is smaller than that of the electric power take-out electrode (i.e., the upper electrode 53 or the rear electrode 63), electric current is carried through such a thin intermediate electrode 57 or a buffer layer 61 due to the quantum tunneling effect. Thus, a slightly large specific resistance is not a practical problem.

According to the present embodiment, in the process of forming the intermediate electrode 57 or the buffer layer 61, the target is sputtered while introducing oxygen gas.
With this configuration, an oxygen-rich ZnO-based film is provided, with which a highly light transmissive transparent conductive film can be obtained. Note that oxygen atom-containing gas, instead of oxygen gas, may be introduced.

It should be noted that the technical scope of the invention is not limited to the foregoing embodiments and various modification may be made to the embodiments without departing from the scope of the invention.
Materials and configurations described above are for illustrative purposes only and may be changed suitably.
For example, although the sputtering apparatus according to the embodiment supports a substrate in a vertical position for the sputtering, the invention may be implemented with a sputtering apparatus which supports the substrate in a horizontal position.
Although the magnetic circuit unit according to the embodiment has the second magnet with second polarity disposed to surround the first magnet with first polarity, a third magnet with first polarity may additionally be disposed to surround the second magnet to provide a magnetic circuit unit.
Although the present embodiment is directed to a tandem solar cell, the invention may similarly be applied to a single-junction solar cell. A single-junction solar cell refers to a solar cell similar to that illustrated in FIG. 5 but with no intermediate electrode or a bottom cell.

Although the DC power supply (i.e., the direct current power supply) is employed in the sputtering cathode mechanism according to the embodiment, the DC power supply and a RF power supply (i.e., a high-frequency power supply) may also be employed at the same time. When only the DC power supply is employed, specific resistance of the ZnO-based film (2000-angstrom thick) deposited at the sputtering voltage 300V is 436.6 µΩ cm as illustrated in FIG. 8. On the contrary, if a low current (4A) DC power supply and a 350W RF power supply are employed together, for example, specific resistance of the ZnO-based film (2000-angstrom thick) formed at the sputtering voltage of about 100V with respect to a ZnO-2wt% Al₂O₃ target is 389.4 µΩcm. As described above, when the RF power supply is used together with the DC power supply, the sputtering voltage decreases. According to the decrease of the sputtering voltage, the specific resistance of the ZnO-based film decreases. Therefore, acceleration of the plasma-excited negative ions and bombardment of the negative ions to the substrate can be avoided. As a result, damage to underlying films of the intermediate electrode or the buffer layer can be reduced. That is, with decreased sputtering voltage from the aspect of the power supply in addition to magnetic field strength, specific resistance of the ZnO-based film can be lowered and damage to the underlying films can be avoided.

### [Industrial applicability]

Since the intermediate electrode or the buffer layer are formed with low sputtering voltage, acceleration of plasma-excited negative ions and bombardment of this ions to the substrate can be avoided. Accordingly, in the manufacturing process of the solar cell, damage to underlying films of a photovoltaic cell and the like disposed adjacent to the intermediate electrode or the buffer layer can be reduced. With the sputtering voltage of 340V or less, a thin ZnO-based film with a well-defined crystalline lattice can be deposited, thereby a transparent conductive film with low specific resistance can be obtained.

## Claims

1. A method for manufacturing a solar cell provided with a buffer layer or an intermediate electrode, the buffer layer disposed between a rear electrode and a photovoltaic cell, the rear electrode disposed on the opposite side of a light incidence side and functioning as an electrode for extracting electric power, the intermediate electrode disposed between a plurality of photovoltaic cells and the intermediate electrode or the buffer layer comprising a ZnO-based transparent conductive film, the method comprising:
forming the intermediate electrode or the buffer layer by sputtering a target on which a formation material of the transparent conductive film is provided while applying sputtering voltage to generate a horizontal magnetic field on a surface of the target,
wherein the intermediate electrode or the buffer layer is formed through sputtering at a sputtering voltage of 340V or less.

2. The method for manufacturing a solar cell according to claim 1, wherein:
in the process of forming the intermediate electrode or the buffer layer, the target is sputtered with the maximum horizontal magnetic field strength on the surface thereof being not less than 600 gauss.

3. The method for manufacturing a solar cell according to claim 1, wherein:
in the process of forming the intermediate electrode or the buffer layer, the target is sputtered while introducing oxygen gas or oxygen atom-containing gas.

4. The method for manufacturing a solar cell according to claim 1, wherein:
a magnetic field generating device for generating a horizontal magnetic field on the target surface includes a first magnet with a first polarity and a second magnet with a second polarity disposed along a rear surface of the target; and
the second magnet is disposed to surround the first magnet.

5. The method for manufacturing a solar cell according to claim 1, wherein:
in the process of forming the intermediate electrode or the buffer layer, the target is sputtered while relative positions of the magnetic field generating device for generating a horizontal magnetic field on the target surface and the target are changing.

6. The method for manufacturing a solar cell according to claim 1, wherein:
in the process of forming the intermediate electrode or the buffer layer, the target is sputtered while relative positions of a substrate on which the intermediate electrode or the buffer layer is to be formed and the target are changing.

7. The method for manufacturing a solar cell according to claim 1, wherein:
the sputtering voltage is applied from both a direct current power supply and a high-frequency power supply.
